# EUROPEAN PATENT SPECIFICATION

(11) **EP 4 451 330 B1**
(45) Date of publication and mention of the grant of the patent: **30.09.2026**
(21) Application number: 24166163.6
(22) Date of filing: 26.03.2024
(51) Int. Cl.: H10H 29/01, H10H 29/854, H10H 29/855, H10H 29/853

(54) **LIGHT EMITTING DEVICE AND METHOD OF MANUFACTURING SAME**
LICHTEMITTIERENDE VORRICHTUNG UND VERFAHREN ZU IHRER HERSTELLUNG
DISPOSITIF ÉLECTROLUMINESCENT ET SON PROCÉDÉ DE FABRICATION

(30) Priority: 27.03.2023 JP 2023050292; 06.12.2023 JP 2023206423
(43) Date of publication of application: 23.10.2024
(73) Proprietor: Nichia Corporation, Anan-shi, Tokushima 774-8601 (JP)
(72) Inventor: OZEKI, Kenji, Anan-shi, Tokushima, 774-8601 (JP); HAYASHI, Midori, Anan-shi, Tokushima, 774-8601 (JP)
(74) Representative: Betten & Resch

(56) References cited:
- EP-A1- 3 675 189
- US-A1- 2022 344 535

## Description

### TECHNICAL FIELD

The present disclosure relates to a light emitting device and a method of manufacturing the same.

### BACKGROUND

Japanese Patent Publication No. 2020-92231 describes a light emitting device including: a substrate; a plurality of light emitting elements arranged on the substrate; a plurality of light transmissive members disposed on the respective light emitting elements; and a covering body provided in a region between adjacent light transmissive members and covering the lateral surfaces of the plurality of light transmissive members.

EP 3 675 189 A1 discloses a light emitting device manufacturing method.

US 2022/344535 A1 discloses a light-emitting device including: a structure including: a layered body including: a light-emitting element; and a light-reflective member.

### SUMMARY

It is an object of the present disclosure to increase a luminance difference between a turned-on light emitting element and a turned-off light emitting element in a light emitting device including a plurality of light emitting elements.

The invention is defined by the independent claims. Dependent claims specify embodiments thereof.

### BRIEF DESCRIPTION OF THE DRAWINGS

Other objects and further features of the present disclosure will be apparent from the following detailed description when read in conjunction with the accompanying drawings, in which:
FIG. 1 is a perspective view schematically illustrating a light emitting device according to an embodiment;
FIG. 2 is a top view schematically illustrating the light emitting device according to the embodiment;
FIG. 3 is a top view schematically illustrating a wiring substrate constituting part of the light emitting device according to the embodiment;
FIG. 4 is a vertical cross-sectional view of the light emitting device taken through line IV-IV of FIG. 2;
FIG. 5 is a is a partially enlarged view of a portion A of FIG. 4;
FIG. 6 is a diagram illustrating the measurement results of contrast in Examples 1 to 4 and Comparative Example 1;
FIG. 7 is a diagram illustrating the measurement results of contrast in Examples 5 to 8 and Comparative Example 2;
FIG. 8A and FIG. 8B are partial cross-sectional views (part 1) illustrating a method of manufacturing a light emitting device according to an embodiment;
FIG. 9A and FIG. 9B are partial cross-sectional views (part 2) illustrating the method of manufacturing the light emitting device according to the embodiment;
FIG. 10A and FIG. 10B are partial cross-sectional views (part 3) illustrating the method of manufacturing the light emitting device according to the embodiment which is not part of the invention;
FIG. 11 is a partial cross-sectional view schematically illustrating a light emitting device according to a first modification of the embodiment;
FIG. 12 is a top view schematically illustrating a light emitting device according to a second modification of the embodiment;
FIG. 13 is a vertical cross-sectional view schematically illustrating a light emitting device according to a third modification of the embodiment;
FIG. 14 is a top view schematically illustrating a light emitting device according to a fourth modification of the embodiment which is not part of the invention;
FIG. 15 is a vertical cross-sectional view of the light emitting device taken through line XV-XV of FIG. 14;
FIG. 16 is a top view schematically illustrating a light emitting device according to a fifth modification of the embodiment which is not part of the invention; and
FIG. 17 is a vertical cross-sectional view of the light emitting device taken through line XVII-XVII of FIG. 16.

### DETAILED DESCRIPTION

In the following, a manufacturing method according to an embodiment of the present disclosure and a light emitting device obtained by the manufacturing method (hereinafter may be referred to as a "light emitting device according to an embodiment") will be described with reference to the accompanying drawings. In the following description, terms indicating specific directions and positions (for example, "upper," "upward," "lower," "downward," and other terms including these terms) are used as necessary. These terms are used to facilitate understanding of the present invention with reference to the drawings, and the technical scope of the present invention is not limited by the meaning of these terms. The same reference numerals appearing in a plurality of drawings refer to the same or similar portions or members.

Further, the following embodiments exemplify a light emitting device and the like to embody the technical idea of the present invention, and the present invention is not limited to the following description. In addition, unless otherwise specified, the dimensions, materials, shapes, relative arrangements, and the like of components described below are not intended to limit the scope of the present invention thereto, but are described as examples. The contents described in one embodiment can be applied to other embodiments and modifications. The sizes, positional relationships, and the like of members illustrated in the drawings may be exaggerated for clearer illustration. Furthermore, in order to avoid excessive complication of the drawings, a schematic view in which some elements are not illustrated may be used, or an end view illustrating only a cut surface may be used as a cross-sectional view.

### <Light Emitting Device 1 According to Embodiment>

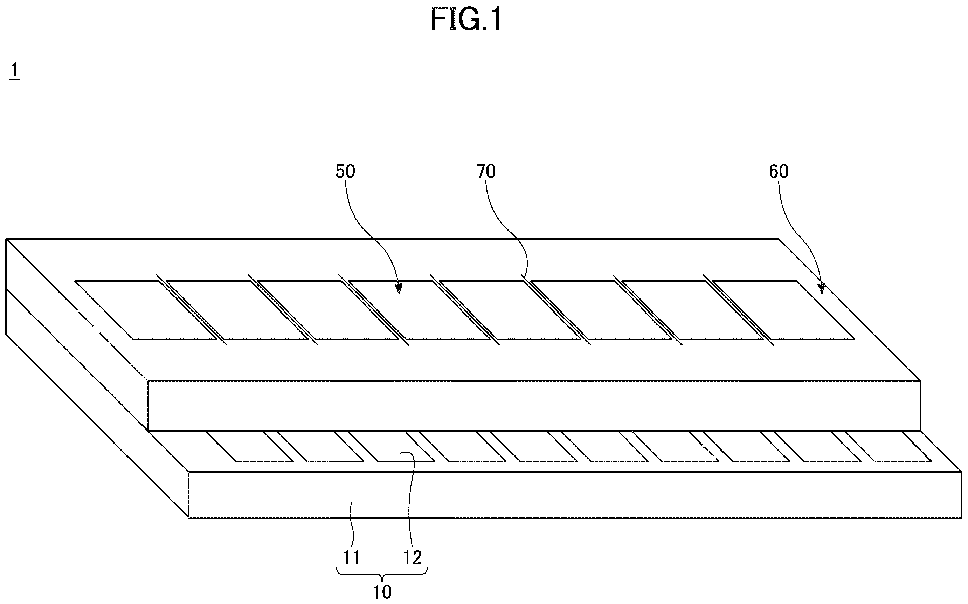

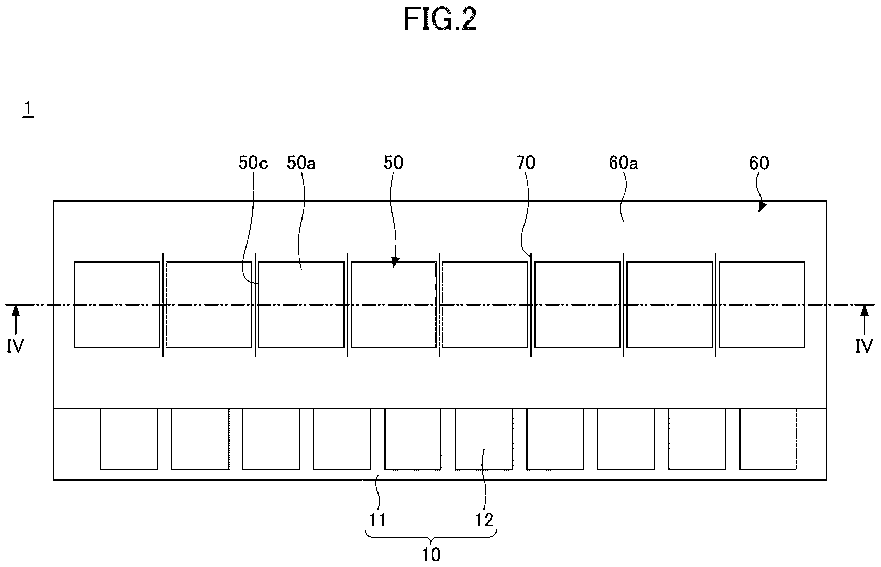

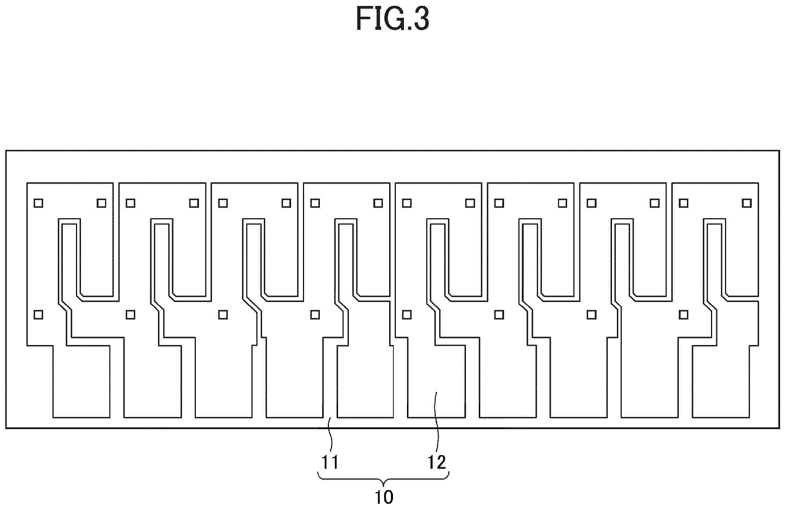

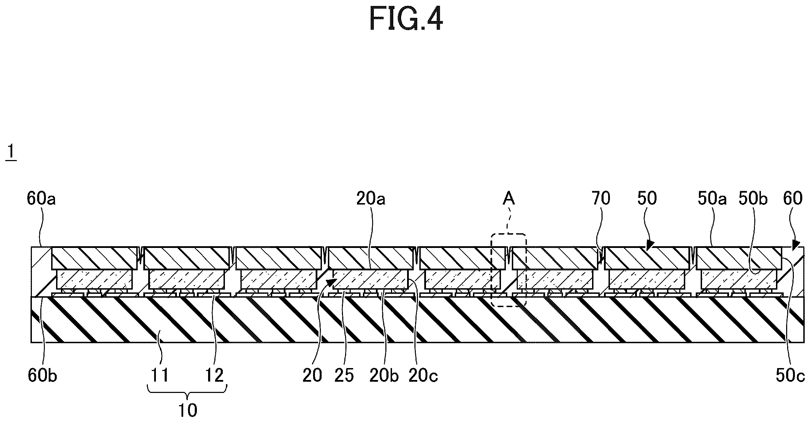

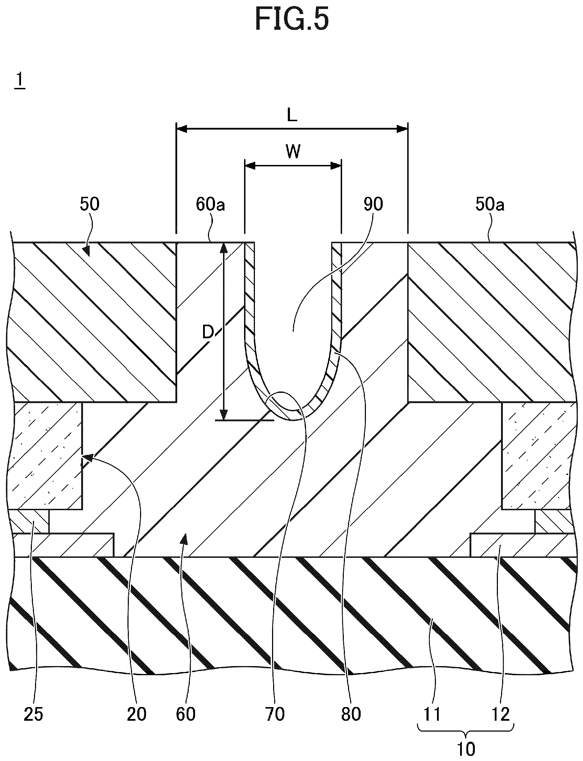

FIG. 1 is a perspective view schematically illustrating a light emitting device according to an embodiment. FIG. 2 is a top view schematically illustrating the light emitting device according to the embodiment. FIG. 3 is a top view schematically illustrating a wiring substrate constituting part of the light emitting device according to the embodiment. FIG. 4 is a vertical cross-sectional view of the light emitting device taken through line IV-IV of FIG. 2. FIG. 5 is a partially enlarged view of a portion A of FIG. 4. As used herein, the term "vertical cross section" refers to a cross section of a light emitting device 1 taken along a plane perpendicular to upper surfaces 20a of light emitting elements 20.

As illustrated in FIG. 1 through FIG. 5, the light emitting device 1 includes a wiring substrate 10, a plurality of light emitting elements 20, a plurality of light transmissive members 50, and a covering member 60, a groove 70 (a first groove), a light shielding member 80, and an air layer 90. In the light emitting device 1, each of the light emitting elements 20 can independently emit light.

In the light emitting device 1, the light emitting elements 20 are disposed on the wiring substrate 10. Further, the light emitting device 1 may include a protective element that is disposed on the wiring substrate 10 and protects the light emitting elements 20. The protective element is, for example, a Zener diode. Each of the light emitting elements 20 has an upper surface 20a, a plurality of lateral surfaces 20c connected to the upper surface 20a, and a lower surface 20b opposite to the upper surface 20a. The plurality of lateral surfaces 20c are connected to the upper surface 20a and the lower surface 20b. In other words, each of the lateral surfaces 20c has outer edges connected to the outer edge of the upper surface 20a and to the outer edge of the lower surface 20b. Light is emitted from the upper surface 20a, the lower surface 20b, and the lateral surface(s) 20c of each of the light emitting elements 20.

The light emitting elements 20 each has the upper surface 20a having a substantially rectangular shape. For example, the exterior shape of each of the light emitting elements 20 is a substantially cubic shape or a substantially rectangular parallelepiped shape. In this case, the upper surface 20a and the lower surface 20b of each of the light emitting element 20 has a substantially rectangular shape, and each of the light emitting elements 20 has four lateral surfaces 20c each having a substantially rectangular shape. The upper surface 20a of each of the light emitting elements 20 may have a polygonal shape such as a triangular shape or a hexagonal shape. Further, the exterior shape of each of the light emitting elements 20 may be a columnar shape or a frustum shape having a polygonal-shaped upper surface.

The plurality of light transmissive members 50 are disposed on the respective light emitting elements 20. The number of the light transmissive members 50 is, for example, the same as number of the light emitting elements 20. A distance L between adjacent light transmissive members 50 is, for example, 50 µm or less. Each of the light transmissive members 50 has an upper surface 50a, a lower surface 50b opposite to the upper surface 50a, and lateral surfaces 50c between the upper surface 50a and the lower surface 50b. The upper surface 50a of each of the light transmissive members 50 constitutes the upper surface of the light emitting device 1 and serves as the main light emitting surface of the light emitting device 1. The lower surface 50b of the light transmissive member 50 is bonded to the upper surface 20a of the light emitting element 20. The light transmissive members 50 may be bonded to the light emitting elements 20 via a light transmissive adhesive, which is formed of a silicone resin or the like, provided between the lower surface 50b of the light transmissive member 50 and the upper surface 20a of the light emitting element 20. Alternatively, the lower surface 50b of the light transmissive member 50 may directly contact the upper surface 20a of the light emitting element 20. The light transmissive member 50 is disposed such that the lower surface 50b of the light transmissive member 50 is substantially parallel to the upper surface 20a of the light emitting element 20. The shape of the lower surface 50b of the light transmissive member 50 is preferably similar to the shape of the upper surface 20a of the light emitting element 20. For example, if the upper surface 20a of the light emitting element 20 has a rectangular shape, the lower surface 50b of the light transmissive member 50 preferably has a rectangular shape. The number of the light transmissive members 50 included in the light emitting device 1 may be smaller than the number of the light emitting elements 20. Examples of a configuration in which the light emitting device 1 includes the plurality of light transmissive members smaller in number than the plurality of light emitting elements 20 includes a configuration in which at least one of the plurality of light transmissive members covers some of the light emitting elements 20, collectively.

The lower surface 50b of the light transmissive member 50 is a flat surface. The upper surface 50a of the light transmissive member 50 may be a flat surface that is parallel to the lower surface 50b. Alternatively, a portion of the upper surface 50a or the entire upper surface 50a needs not necessarily be parallel to the lower surface 50b. The lateral surface 50c of the light transmissive member 50 may be a surface perpendicular or inclined to the upper surface 50a and/or the lower surface 50b, or a curved surface, or the like. A portion of or the entirety of the surfaces of the light transmissive members 50 may have projections and recesses.

The area of the lower surface 50b of the light transmissive member 50 is larger than the area of the upper surface 20a of the light emitting element 20. In this case, the light transmissive member 50 is preferably disposed such that the lower surface 50b of the light transmissive member 50 surrounds the outer periphery of the light emitting element 20 in a top view. Further, the area of the lower surface 50b of the light transmissive member 50 may be smaller than or the same as the area of the upper surface 20a of the light emitting element 20.

The covering member 60 covers the lateral surfaces 50c of the light transmissive members 50 and the lateral surfaces 20c of the light emitting elements 20, collectively. The upper surfaces 50a of the light transmissive members 50 are exposed from the covering member. The covering member 60 may cover at least a portion of the upper surface of the wiring substrate 10. Further, if the light emitting device 1 includes the protective element, the covering member 60 preferably covers the upper surface, the lower surface, and the lateral surfaces of the protective element. Further, the covering member 60 may cover the lower surfaces 20b of the light emitting elements 20.

The covering member 60 covers the lateral surfaces 20c of the light emitting elements 20, so that light emitted from the lateral surfaces 20c of the light emitting elements 20 is reflected by the covering member 60. Further, the covering member 60 covers the lower surfaces 20b of the light emitting elements 20, so that light traveling below the light emitting elements 20 is reflected by the covering member 60. Accordingly, the light extraction efficiency of the light emitting device 1 can be improved. The covering member 60 may be constituted by a single member or a plurality of members.

In the light emitting device 1, the covering member 60 and a base 11 of the wiring substrate 10 constitute the lateral surfaces of the light emitting device 1. The lateral surfaces of the covering member 60 and the lateral surfaces of the base 11, constituting the lateral surfaces of the light emitting device 1, can be, for example, coplanar with each other. Further, an upper surface 60a of the covering member 60 can be, for example, coplanar with the upper surfaces 50a of the light transmissive members 50.

The groove 70 opens at the upper surface 60a of the covering member 60 and is provided between adjacent light transmissive members 50. In a vertical cross section of the light emitting device 1 cut in a direction in which the light transmissive members 50 are arranged, a maximum width W of the groove 70 is preferably 20 µm or less. Accordingly, the distance between the adjacent light transmissive members 50 can be reduced. The groove 70 is provided between the facing sides of the adjacent light transmissive members 50 in a top view. The groove 70 may be provided at least between the facing sides of the adjacent light transmissive members 50. The groove 70 may be one continuous groove or may be a plurality of grooves 70 arranged intermittently. In particular, the groove 70 is preferably linearly provided between the facing sides of the adjacent light transmissive members 50. The groove 70 may extend from between the facing sides of the adjacent light transmissive members 50 and both ends of the groove 70 may reach the opposite long sides of the covering member 60 in a top view. Further, in a top view, the groove 70 may be a groove individually surrounding the light transmissive members 50, for example, a grid-shaped groove surrounding the light transmissive members 50.

The light shielding member 80 covers the surface of the covering member 60 that defines the groove 70. The thickness of the light shielding member 80 covering the surface of the covering member 60 can be, for example, approximately 1 µm or more and 5 µm or less. The light shielding member 80 is adapted to reflect or absorb incident light. The light shielding member 80 preferably has a transmittance of 30% or less and more preferably 5% or less with respect to incident light.

The air layer 90 is positioned on the light shielding member 80 in the groove 70. That is, the light shielding member 80 does not fill the groove 70, and the light emitting device 1 has the air layer 90 at least on the upper surface 50a side between the facing lateral surfaces 50c of the adjacent light transmissive members 50. The refractive index of the covering member 60 and of the light shielding member 80 are greater than the refractive index of the air layer 90. The refractive index of the covering member 60 and of the light shielding member 80 is preferably 1.2 or more and more preferably 1.4 or more.

As described above, the light emitting device 1 has the groove 70 opening at the upper surface 60a of the covering member 60 and provided between the adjacent light transmissive members 50. In addition, the light emitting device 1 includes the light shielding member 80 covering the surface of the covering member 60 defining the groove 70. With this configuration, light incident on a light transmissive member 50 from a light emitting element 20 and exiting from the lateral surface 50c of the light transmissive member 50, and light existing from the lateral surface 20c of the light emitting element 20 are shielded by the light shielding member 80. Therefore, light propagating between the lateral surfaces 50c of adjacent light transmissive members 50 can be reduced. As a result, interference of light between adjacent light emitting elements 20 can be reduced.

For example, if one of two adjacent light emitting elements 20 is turned on and the other light emitting element 20 is turned off, light from the turned-on light emitting element 20 can be suppressed from propagating through one light transmissive member 50 and/or through the covering member 60 to another light transmissive member 50 disposed on the turned-off light emitting element 20, and leaking from the other light transmissive member 50 disposed on the turned-off light emitting element 20. As a result, a luminance difference between the turned-on light emitting element 20 and the turned-off light emitting element 20 can be increased on the upper surface of the light emitting device 1. In other words, light can be emitted individually from each of the light emitting elements 20 without substantially causing interference of light between the adjacent light emitting elements 20.

Further, as the distance between the adjacent light emitting elements 20 decreases, propagation of light from each of the adjacent light emitting elements 20 is more likely to occur. Therefore, the effect of reducing propagation of light from each of the adjacent light emitting elements 20 increases as the distance between the adjacent light emitting elements 20 decreases. That is, the light emitting device 1, in which propagation of light from each of the adjacent light emitting elements 20 is suppressed and the pitch between the adjacent light emitting elements 20 is narrowed, can be achieved.

Further, the light emitting device 1 has the air layer 90 positioned on the light shielding member 80 in the groove 70. The refractive index of the light shielding member 80 is greater than the refractive index of the air layer 90. Thus, light transmitted through the light shielding member 80 is easily reflected at the interface between the light shielding member 80 and the air layer 90 due to a refractive index difference between the light shielding member 80 and the air layer 90. Therefore, propagation of light toward the lateral surface 20c of each of the adjacent light emitting elements 20 can be further reduced as compared to when the groove 70 is filled with the light shielding member 80 (that is, as compared to when the light emitting device 1 does not have any air layer 90 between adjacent light transmissive members). As a result, a luminance difference between the turned-on light emitting element 20 and the turned-off light emitting element 20 can be further increased. The effect of reducing propagation of light by this structure is particularly effective for a narrow-pitch light emitting device in which the distance L between adjacent light transmissive members 50 is 50 µm or less.

The light shielding member 80 covering the covering member 60 contacts the air layer 90. Specifically, in the light emitting device 1, the facing lateral surfaces of adjacent light transmissive members 50 are covered by the light shielding member 80 with the covering member 60 interposed therebetween. In addition, the air layer 90 is provided over the light shielding member 80 covering the facing lateral surfaces of the adjacent light transmissive members 50. Accordingly, heat generated by the light shielding member 80 due to light from the light emitting elements 20 can be dissipated through the air layer. That is, the light emitting device 1 can secure an efficient heat dissipation path by having the air layer 90 between the facing lateral surfaces of the adjacent light transmissive members 50. As a result, the possibility of deterioration of the covering member 60 due to heat generated by the light shielding member 80 can be reduced.

In the light emitting device 1, the relationship between a maximum depth D of the groove 70 from the upper surface 60a of the covering member 60 and the maximum width W of the groove 70 is preferably maximum width W < maximum depth D. Accordingly, light incident on a light transmissive member 50 from one of the light emitting elements 20 and exiting from the lateral surface 50c of the light transmissive member 50 is easily shielded by the light shielding member 80. Thus, interference of light between adjacent light transmissive members 50 can be further reduced. As a result, a luminance difference between the turned-on light emitting element 20 and the turned-off light emitting element 20 can be further increased on the upper surface of the light emitting device 1.

The deepest portion of the groove 70 may be located at a position shallower than the lower surfaces 50b of the light transmissive members 50 or may be located at a position deeper than the lower surfaces 50b of the light transmissive members 50. In particular, the maximum depth D is preferably a depth that is half or more of the thickness of the light transmissive members 50. Accordingly, the light shielding effect of the light shielding member 80 can be further enhanced. Thus, interference of light between the adjacent light transmissive members 50 can be further reduced. As a result, a luminance difference between the turned-on light emitting element 20 and the turned-off light emitting element 20 can be further increased on the upper surface of the light emitting device 1.

Further, the maximum depth D is more preferably greater than or equal to the thickness of the light transmissive members 50. Accordingly, the light shielding effect of the light shielding member 80 can be further enhanced. Thus, interference of light between the adjacent light transmissive members 50 can be further reduced. As a result, a luminance difference between the turned-on light emitting element 20 and the turned-off light emitting element 20 can be further increased on the upper surface of the light emitting device 1.

Further, the maximum depth D particularly preferably reaches approximately half of the thickness of the light emitting elements 20. Accordingly, light emitted laterally from the lateral surface 20c of one of the light emitting elements 20 is shielded by the light shielding member 80 and does not easily propagate to the adjacent light emitting element 20 and an adjacent light transmissive member 50. Thus, interference of light between the adjacent light emitting elements 20 can be particularly reduced. As a result, a luminance difference between the turned-on light emitting element 20 and the turned-off light emitting element 20 can be particularly increased on the upper surface of the light emitting device 1. The deepest portion of the groove 70 may be at a position deeper than the lower surfaces 20b of the light emitting elements 20.

In a top view, grooves 70 may also be provided beside the lateral surfaces 50c of light transmissive members 50 located on both ends of the light emitting device 1 in the direction in which the light transmissive members 50 are arranged (that is, between the lateral surfaces 50c of the light transmissive members 50 and the outer edge of the covering member 60). Accordingly, light leaking laterally from the outer edge of the covering member 60 in a top view (that is, leakage light from the lateral surfaces of the light emitting device 1) can be further reduced.

### (Examples 1 to 4 and Comparative Example 1)

Experiments were performed by measuring contrast when the maximum depth D of the groove 70 was varied in the light emitting device 1 illustrated in FIG. 1 through FIG. 5. As a comparative example, an experiment was conducted by measuring contrast when no groove 70 is formed.

In Example 1, a light emitting device was produced in which the thickness of light emitting elements 20 was 150 µm, the thickness of light transmissive members 50 was 65 µm, the thickness of a light shielding member 80 was 2 µm, the interval between adjacent light transmissive members 50 was 50 µm, and the maximum width W of a groove 70 was 10 µm, and the maximum depth D of the groove 70 was 65 µm. In this light emitting device, contrast when one of the adjacent light emitting elements 20 is turned on and the other light emitting element 20 is turned off was measured. As used herein, contrast is defined as "contrast = A/B:1", where A denotes the luminance of light emitted through a light transmissive member 50 located on the turned-on light emitting element 20, and B denotes the luminance of light emitted through a light transmissive member 50 located on the turned-off light emitting element 20. The luminance was measured by using an imaging color luminance meter (ProMetric I8, manufactured by Radiant Vision Systems, LLC).

In Example 2, a light emitting device was produced in the same manner as Example 1 except that the maximum depth D of a groove 70 was 80 µm. Then, contrast was measured in the same manner as Example 1.

In Example 3, a light emitting device was produced in the same manner as Example 1 except that the maximum depth D of a groove 70 was 93 µm. Then, contrast was measured in the same manner as Example 1.

In Example 4, a light emitting device was produced in the same manner as Example 1 except that the maximum depth D of a groove 70 was 145 µm. Then, contrast was measured in the same manner as Example 1.

In Comparative Example 1, a light emitting device was produced in the same manner as Example 1 except that the maximum depth D of a groove 70 was 0 µm. Then, contrast was measured in the same manner as Example 1.

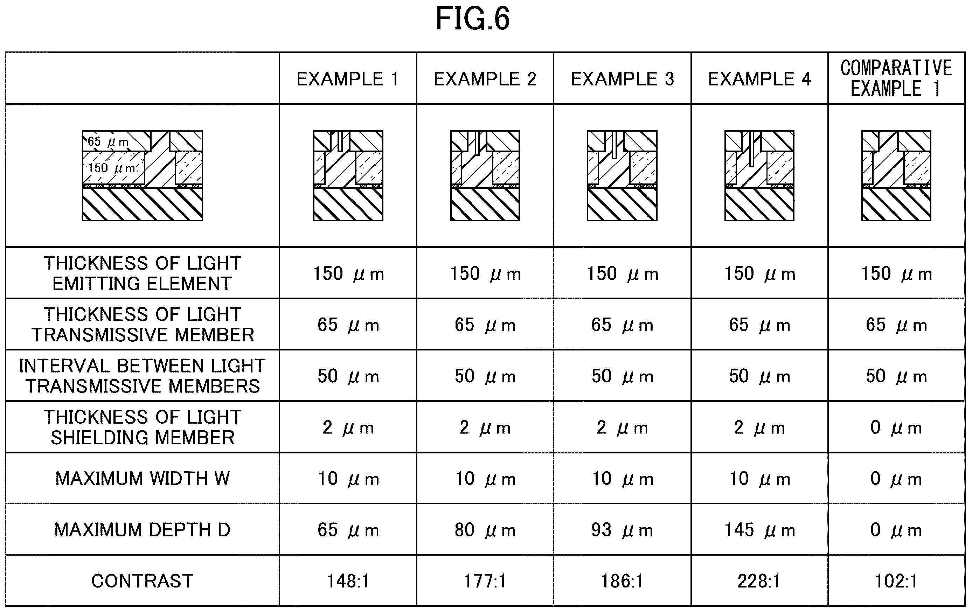

FIG. 6 is a diagram illustrating the measurement results of the contrast in Examples 1 to 4 and Comparative Example 1. In FIG. 6, the second row from the top depicts schematic illustrations of the maximum depths D of the grooves 70.

In FIG. 6, when the measurement results of the contrast in Example 1 and Comparative Example 1 were compared, the contrast in Comparative Example 1 was 102:1, whereas the contrast in Example 1 was 148:1. It was confirmed that, providing the groove 70 greatly improved the contrast in Example 1 as compared to the contrast in Comparative Example 1. Similarly, it was confirmed that the contrast in each of Examples 2 to 4 was greatly improved as compared to the contrast in Comparative Example 1. In addition, when the measurement results of the contrast in Examples 1 to 4 were compared, it was indicated that as the maximum depth D increased, the contrast was improved (that is, the luminance difference increased). In particular, in Example 4 in which the maximum depth D reached half or more of the thickness of light emitting elements 20, the contrast was 228:1, which was more than twice the contrast in Comparative Example 1.

### (Examples 5 to 8 and Comparative Example 2)

In Examples 5 to 8 and Comparative Example 2, light emitting devices were produced in the same manner as Examples 1 to 4 and Comparative Example 1, except that the thickness of each light emitting element 20 was 60 µm. Then, contrast was measured in the same manner as Example 1.

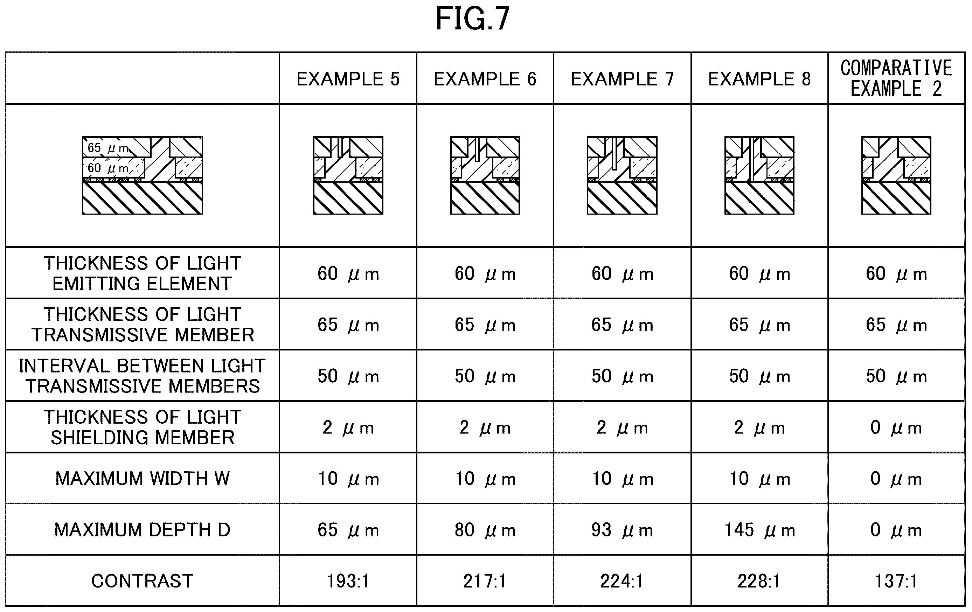

FIG. 7 is a diagram illustrating the measurement results of the contrast in Examples 5 to 8 and Comparative Example 2. In FIG. 7, the second row from the top depicts schematic illustrations of the maximum depths D of grooves 70.

In FIG. 7, similar to FIG. 6, the experimental results indicated that, providing the grooves 70 greatly improved the contrast in Examples 5 to 8 as compared to the contrast in Comparative Example 2, and the contrast was improved as the maximum depth D increased. However, in Example 8 in which the maximum depth D was deeper than the lower surfaces of light emitting elements 20, the contrast was slightly improved as compared to Example 7 in which the maximum depth D reached approximately half of the thickness of light emitting elements 20. From this result, it was confirmed that sufficient contrast was obtained when the maximum depth D reached approximately half of the thickness of the light emitting elements 20.

In FIG. 6 and FIG. 7, when examples (for example, Example 1 and Example 5) having the same maximum depth D are compared, it can be found that the contrast in FIG. 7, in which the light emitting element 20 is thin, is equal to or superior to the contrast in FIG. 6 in which light emitting element 20 is thick. This is because light propagating between the facing lateral surfaces 20c of two adjacent light emitting elements 20 and light propagating from one of the two adjacent light emitting elements 20 to a light transmissive member 50 disposed on the other light emitting element 20 can be reduced as the thickness of the light emitting elements 20 decreases. However, in FIG. 6 and FIG. 7, the difference in contrast between examples having the same maximum depth D decreases as the maximum depth of the groove 70 increases. Therefore, it is conceivable that, in each of these examples, improvement of contrast is largely affected by the maximum depth D of the groove 70 (that is, the distance from the light emitting surface of the light emitting device to the bottom portion of the groove 70), rather than the ratio of the depth of the groove 70 to the thickness of the covering member 60.

Each component of the light emitting device 1 according to the embodiment will be described in detail below.

### [Wiring Substrate 10]

The wiring substrate 10 is a member on which a light emitting element 20 is disposed. The wiring substrate 10 includes the base 11 and wiring 12 disposed on the upper surface of the base 11. The base 11 supports the wiring 12. The wiring 12 is used to supply power to the light emitting element 20 from the outside. In addition to the wiring 12, the wiring substrate 10 may include wiring disposed on the lower surface of the base 11.

The base 11 has, for example, a substantially cubic shape or a substantially rectangular parallelepiped shape. The base 11 is preferably formed of a material through which light emitted from the light emitting element 20, external light, or the like is not easily transmitted. Examples of the material of the base 11 include ceramics such as aluminum oxide, aluminum nitride, silicon nitride, and mullite; resins such as epoxy resins, silicone resins, modified epoxy resins, urethane resins, phenol resins, polyimide resins, bismaleimide-triazine resins (BT resins), and polyphthalamide; semiconductors such as silicon; metals such as copper and aluminum; a single material of graphite; and composite materials of these materials. Among them, a ceramic having good heat dissipation properties can be suitably used as the material of the base 11.

Examples of the material of the wiring 12 include metals such as iron, copper, nickel, aluminum, gold, silver, platinum, titanium, tungsten, and palladium, and an alloy including at least one of these metals. If wiring is provided on the lower surface of the base 11, the wiring may include an anode electrode and a cathode electrode that are electrically connected to an external power source. Further, if the wiring substrate 10 includes the wiring on the lower surface of the base 11, relay wiring for connecting the wiring 12 to the wiring disposed on the lower surface of the base 11 may be provided inside the base 11 and/or on the lateral surface of the base 11. Further, the wiring 12 may include wiring for heat dissipation on the lower surface of the base 11, in addition to an anode electrode and a cathode electrode that are electrically connected to the light emitting elements 20.

The wiring substrate 10 does not necessarily include the wiring on the lower surface of the base 11. In this case, the anode electrode and the cathode electrode that are electrically connected to the external power source may be provided on the upper surface or the lateral surface of the base 11.

The light emitting device 1 may have a configuration in which the wiring substrate 10 has a recessed portion in the upper surface thereof, and the light emitting element 20 is disposed on the bottom of the recessed portion. Further, the light emitting device 1 may have a configuration in which the wiring substrate 10 is not included. For example, the light emitting device 1 may have a configuration in which a metal member, exposed from the covering member 60 covering the lower surface 20b of the light emitting element 20, is included as an electrode of the light emitting device 1.

### (Light Emitting Element 20)

A semiconductor light emitting element such as a light emitting diode (LED) chip or a semiconductor laser diode (LD) chip can be suitably used as the light emitting element 20. The light emitting element 20 can have discretionary shape, discretionary size, and the like. The light emitting element 20 includes a plurality of electrodes on the lower surface 20b, for example. The light emitting element 20 is disposed on the wiring substrate 10. The light emitting element 20 is flip-chip mounted on the wiring substrate 10 such that the lower surface 20b, on which the electrodes are provided, faces the wiring substrate 10, for example. The electrodes of the light emitting element 20 are electrically connected to the wiring 12. The electrodes of the light emitting element 20 can be connected to the wiring 12 by using a publicly-known conductive member 25 such as eutectic solder, conductive paste, or bumps. The electrodes of the light emitting element 20 may be directly connected to the wiring 12 without using the conductive member 25.

The light emitting element 20 includes, for example, a semiconductor structure and a support substrate that supports the semiconductor structure. The semiconductor structure includes an n-side semiconductor layer, a p-side semiconductor layer, and an active layer interposed between the n-side semiconductor layer and the p-side semiconductor layer. The active layer may be a single quantum well (SQW) structure or a multiple quantum well (MQW) structure including a plurality of well layers. The semiconductor structure includes a plurality of semiconductor layers formed of nitride semiconductors. The nitride semiconductors include semiconductors of all compositions obtained by varying the composition ratio x and y within their ranges in the chemical formula InₓAl_{y}Ga_{1-x-y}N (0 ≤ x, 0 ≤ y, x + y ≤ 1). The peak wavelength of light from the active layer can be appropriately selected in accordance with the purpose. The active layer is configured to emit, for example, visible light or ultraviolet light.

The semiconductor structure may include a plurality of light emitting parts each including an n-side semiconductor layer, an active layer, and a p-side semiconductor layer. If the semiconductor structure includes a plurality of light emitting parts, well layers in the light emitting parts may emit light having different peak emission wavelengths or the same peak emission wavelength. The same peak emission wavelength may include a variation of about several nanometers. A combination of peak emission wavelengths of light from the plurality of light emitting parts can be appropriately selected. For example, if the semiconductor structure includes two light emitting parts, combinations of light emitted from the light emitting parts include blue light and blue light, green light and green light, red light and red light, ultraviolet light and ultraviolet light, blue light and green light, blue light and red light, green light and red light, and the like. For example, if the semiconductor structure includes three light emitting parts, combinations of light emitted from the light emitting parts include blue light, green light, and red light. Each of the light emitting parts may include one or more well layers emitting light having different peak emission wavelengths from those of other well layers.

The light emitting element 20 may include one semiconductor structure on one support substrate, or may include a plurality of semiconductor stacks on one support substrate. One semiconductor structure may include one light emitting layer, or may include a plurality of light emitting layers. A semiconductor structure having a plurality of light emitting layers may be a structure that includes a plurality of active layers between one n-side semiconductor layer and one p-side semiconductor layer, or may be a repeatedly stack structure that successively includes an n-type semiconductor layer, an active layer, and a p-type semiconductor layer.

In the light emitting element 20, the plurality of electrodes are disposed on a semiconductor structure. The electrodes include an n-electrode connected to an n-side semiconductor layer and a p-electrode connected to a p-side semiconductor layer. The p-electrode and the n-electrode may be disposed on different surfaces or the same surface of a semiconductor stack. In this example, the plurality of electrodes including the p-electrode and the n-electrode are disposed on the same surface of the semiconductor structure. The surface of the semiconductor structure on which the plurality of electrodes are disposed constitutes the lower surface 20b of the light emitting element 20, and the surface of the support substrate on the side opposite to the semiconductor structure constitutes the upper surface 20a of the light emitting element 20. As the support substrate, an insulating substrate, such as sapphire or a spinel (MgAl₂O₄), or a nitride-based semiconductor substrate such as gallium nitride can be used. The support substrate can be preferably formed of a light-transmissive material in order to extract light emitted from the active layer through the support substrate.

### (Light Transmissive Member 50)

A light transmissive member 50 is a member that is disposed on the light emitting element 20 and through which light emitted from the light emitting element 20 is transmitted and exits to the outside. The light transmissive member 50 transmits 60% or more and preferably 70% or more of light emitted from the light emitting element 20 and/or light having a wavelength converted from light emitted from the light emitting element 20 (for example, light having a peak emission wavelength in the wavelength range of 320 nm to 850 nm). The light transmissive member 50 may be formed of any of an inorganic material such as glass, ceramic, or sapphire; a resin including one or more of a silicone resin, a modified silicone resin, an epoxy resin, a modified epoxy resin, an acrylic resin, a phenol resin, and a fluorine resin; and an organic material such as a hybrid resin.

The light transmissive member 50 may contain a phosphor that can convert the wavelength of at least a portion of incident light. As the light transmissive member 50 containing a phosphor, the light transmissive member 50 formed of a sintered body of a phosphor, any of the above-described materials in which phosphor powder is contained, or the like can be used, for example. The light transmissive member 50 may be a light transmissive member in which a light transmissive layer, such as a resin layer containing a phosphor or a glass layer containing a phosphor, is formed on the surface of a formed body such as resin, glass, or ceramic. The light transmissive member 50 may contain a filler such as a diffusing material according to the purpose. If the light transmissive member 50 contains a filler such as a diffusing material, the light transmissive member 50 may be formed of resin, glass, ceramic, or other inorganic material containing a filler. Alternatively, the light transmissive member 50 may be a light transmissive member in which a light transmissive layer, such as a resin layer containing a filler or a glass layer containing a filler, is formed on the surface of a formed body such as resin, glass, or ceramic.

Examples of the phosphor include yttrium aluminum garnet based phosphors (for example, (Y,Gd)₃(Al,Ga)₅O₁₂:Ce), lutetium aluminum garnet based phosphors (for example, Lu₃(Al,Ga) ₅O₁₂:Ce), terbium aluminum garnet based phosphors (for example, Tb₃(Al,Ga)₅O₁₂:Ce), CCA based phosphors (for example, Ca₁₀(PO₄)₆Cl₂:Eu), SAE based phosphors (for example, Sr₄Al₁₄O₂₅:Eu), chlorosilicate based phosphors (for example, Ca₈MgSi₄O₁₆Cl₂:Eu), silicate based phosphors (for example, (Ba,Sr,Ca,Mg)₂SiO₄:Eu), oxynitride based phosphors such as β-SiAlON based phosphors (for example, (Si,Al)₃(O,N)₄:Eu) and α-SiAlON based phosphors (for example, Ca(Si,Al)₁₂(O,N)₁₆:Eu), nitride based phosphors such as LSN based phosphors (for example, (La,Y)₃Si₆N₁₁:Ce), BSESN based phosphors (for example, (Ba,Sr)₂Si₃N₈:Eu), SLA based phosphors (for example, SrLiAl₃N₄:Eu), CASN based phosphors (for example, CaAlSiN₃:Eu), and SCASN based phosphors (for example, (Sr,Ca)AlSiN₃:Eu), fluoride based phosphors such as KSF based phosphors (for example, K₂SiF₆:Mn), KSAF based phosphors (for example, K₂(Si₁₋ₓAlₓ)F₆₋ₓ:Mn, where x satisfies 0 < x < 1), and MGF based phosphors (for example, 3.5MgO·0.5MgF₂·GeO₂:Mn), quantum dots having a Perovskite structure (for example,
(Cs,FA,MA)(Pb,Sn)(F,Cl,Br,I)₃, where FA and MA represent formamidinium and methylammonium, respectively), II-VI quantum dots (for example, CdSe), III-V quantum dots (for example, InP), and quantum dots having a chalcopyrite structure (for example, (Ag,Cu)(In,Ga)(S,Se)₂).

As the light diffusion member, a light diffusion member known in the art can be used. For example, titanium dioxide, silicon dioxide, aluminum oxide, barium titanate, or the like can be used.

Further, if a resin is used as a binder of a phosphor layer or a diffusing material layer, examples of the resin include thermosetting resins such as epoxy resins, modified epoxy resins, silicone resins, and modified silicone resins.

### (Covering Member 60)

The covering member 60 preferably has light shielding properties. Specifically, the covering member 60 preferably has light reflectivity and/or light absorbency. The covering member 60 preferably includes a material that can appropriately reflect light emitted from the light emitting element 20. For example, the covering member 60 preferably has a reflectivity of 60% or more with respect to light emitted from the light emitting element 20. The covering member 60 more preferably has a reflectivity of 70% or more, 80% or more, or 90% or more with respect to light emitted from the light emitting element 20.

For the covering member 60, an insulating material is preferably used. The covering member 60 is a member formed of a light-transmissive resin containing particles of a light reflective substance. Examples of the resin used for the covering member 60 include a resin including one or more of a silicone resin, a modified silicone resin, an epoxy resin, a modified epoxy resin, a urea resin, an acrylic resin, a phenol resin, a bismaleimide-triazine resin, and a polyphthalamide resin, and a hybrid resin of these resins. Among them, a silicone resin having good light resistance, heat resistance, electrical insulation, and flexibility is preferably used. Examples of the light reflective substance include titanium dioxide, silicon dioxide, aluminum oxide, zirconium dioxide, magnesium oxide, potassium titanate, barium titanate, zinc oxide, silicon nitride, aluminum nitride, boron nitride, calcium carbonate, calcium hydroxide, calcium silicate, and a combination thereof. Among them, titanium dioxide (TiO₂) having a relatively high refractive index is preferably used in terms of light reflection.

### (Light Shielding Member 80)

The light shielding member 80 is adapted to reflect or absorb incident light. The light shielding member 80 includes a black filler. The light shielding member 80 is a layer in which a black filler is deposited on the surface of the groove 70. The light shielding member 80 may be, for example, a resin containing a black filler. Examples of the resin include thermosetting resins such as a silicone resin and an epoxy resin. The black filler includes metal oxide particles such as titanium (III) oxide (Ti₂O₃); the black filler includes reduced oxide particles including the same metal as a metal constituting the metal oxide particles included in the covering member 60.

### <Method of Manufacturing Light Emitting Device According to Embodiment>

A method of manufacturing a light emitting device according to an embodiment includes a step of providing an intermediate body including a plurality of light emitting elements, a plurality of light transmissive members disposed on the respective light emitting elements, a covering member exposing upper surfaces of the respective light transmissive members, and covering lateral surfaces of the light transmissive members and lateral surfaces of the light emitting elements, collectively; and a step of forming a groove by irradiating the covering member with laser light such that the groove opens at an upper surface of the covering member and is provided between adjacent ones of the light transmissive members. In the step of forming the groove, a light shielding member and an air layer are formed together with the groove, such that the light shielding member covers a surface of the covering member defining the groove and the air layer is disposed on the light shielding member in the groove.

In the following, the manufacturing steps of the method of manufacturing the light emitting device according to the embodiment will be described with reference to the drawings.

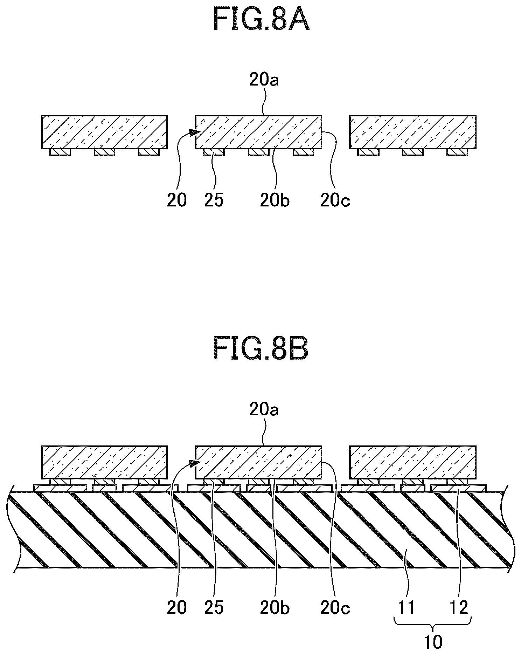

FIG. 8A through FIG. 10B are partial cross-sectional views illustrating the method of manufacturing the light emitting device according to the embodiment. As illustrated in FIG. 8A through FIG. 9B, an intermediate body 100 is provided. Specifically, as illustrated in FIG. 8A, a plurality of light emitting elements 20 are provided. Each of the light emitting elements 20 includes an upper surface 20a, a lower surface 20b, and a plurality of lateral surfaces 20c connected to the upper surface 20a and the lower surface 20b. Then, as illustrated in FIG. 8B, the light emitting elements 20 are disposed on a wiring substrate 10. Each of the light emitting elements 20 is flip-chip mounted on the wiring substrate 10 such that electrodes of each of the light emitting elements 20 face wiring 12.

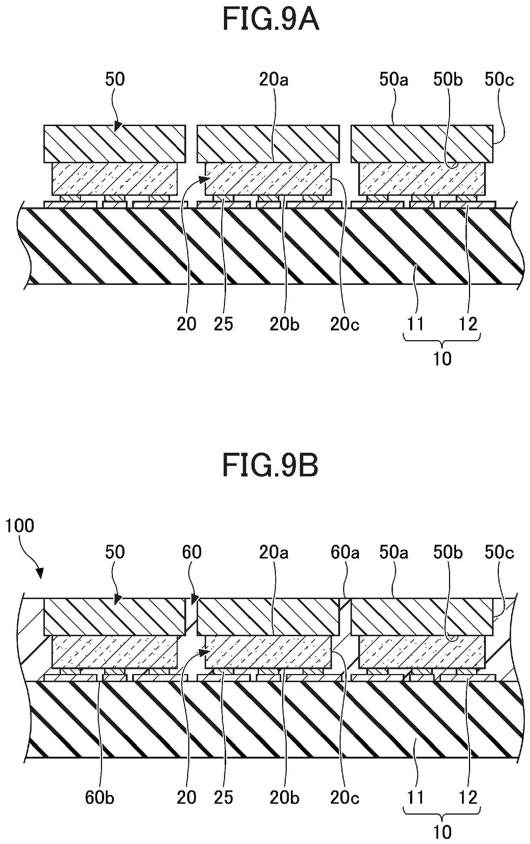

Subsequently, as illustrated in FIG. 9A, light transmissive members 50 are disposed on the respective light emitting elements 20. The light transmissive members 50 can be disposed on upper surfaces 20a of the light emitting elements 20 via an adhesive resin. The light transmissive members 50 may be bonded to the upper surfaces of the light emitting elements 20 by direct bonding such as compression bonding, surface activated bonding, atomic diffusion bonding, or hydroxyl group bonding without using a bonding member such as an adhesive resin.

Subsequently, as illustrated in FIG. 9B, a covering member 60 is disposed on the wiring substrate 10 so as to cover the lateral surfaces 50c of the light transmissive members 50 and the lateral surfaces 20c of the light emitting elements 20, collectively. Specifically, an uncured resin is disposed on the wiring substrate 10 by, for example, potting, spraying, printing, or the like, and the uncured resin is allowed to flow to the lateral surfaces 50c of the light transmissive members 50 and the lateral surfaces 20c of the light emitting elements 20. Thereafter, the uncured resin is cured, and as a result, the covering member 60 is formed. In this manner, the intermediate body 100 can be obtained.

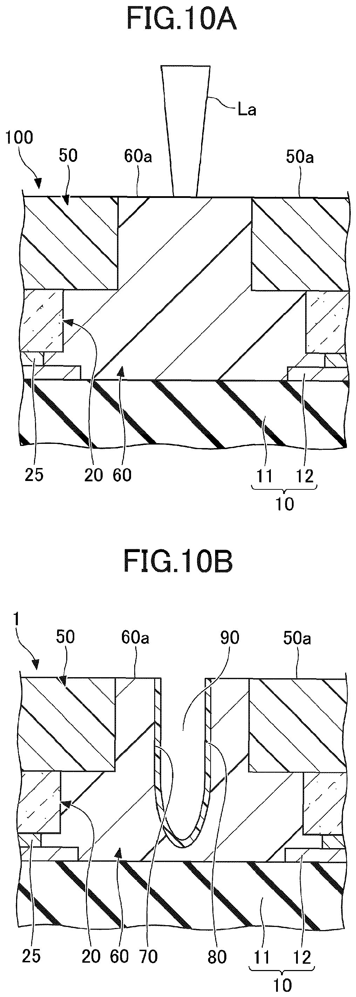

Subsequently, as illustrated in FIG. 10A and FIG. 10B, a groove 70 is formed such that the groove 70 opens at the upper surface of the covering member 60 and is provided between adjacent transmissive members 50. As illustrated in FIG. 10A, in the intermediate body 100, a portion of the covering member 60 located between the adjacent transmissive members 50 is irradiated with laser light La. Before the covering member 60 is irradiated with the laser beam La, the upper surface 60a of the covering member 60 is a substantially flat surface. The laser beam La is, for example, excimer laser light. The spot diameter of the laser light La on the upper surface 60a of the covering member 60 is, for example, 5 µm or more and 10 µm or less. The intensity of the laser beam La is, for example, 1 J/cm² or more and 2 J/cm² or less.

As illustrated in FIG. 10B, by the irradiation of the laser beam La, together with the groove 70 that opens at the upper surface of the covering member 60, a light shielding member 80 and an air layer 90 are formed such that the light shielding member 80 covers the surface of the covering member 60 defining the groove 70 and the air layer 90 is disposed on the light shielding member 80 in the groove 70. The depth of the groove 70 can be increased by increasing the number of shots of the laser light La. In the example of FIG. 10B, a deepest portion of the groove 70 is located at a position deeper than the lower surfaces 20b of the light emitting elements 20. However, the position of the deepest portion of the groove 70 is not limited thereto, and can be adjusted by the number of shots of the laser light La.

The light shielding member 80 is formed by a chemical change of a material, contained in the covering member 60, caused by thermal energy of the laser light La. The light shielding member 80 is formed only on the surface of the covering member 60 defining the groove 70. Therefore, the light shielding member 80 and the air layer 90 are formed together by irradiating the covering member 60 with the laser light La. The air layer 90 is formed on the light shielding member 80 in the groove 70.

As the covering member 60 includes metal oxide particles, the light shielding member 80 includes reduced oxide particles including the same metal as a metal constituting the metal oxide particles included in the covering member 60. The reduced oxide particles are formed by a reduction reaction of the metal oxide particles, included in the covering member 60, caused by thermal energy of the laser light La. For example, if the metal oxide particles included in the covering member 60 are TiO₂, the reduced oxide particles included in the light shielding member 80 are Ti₂O₃.

In order to form the reduced oxide particles, the laser light La preferably has an emission wavelength within a wavelength range in which the light absorptivity of the metal oxide particles is 80% or more. If the laser light La is excimer laser light, the emission wavelength is approximately 250 nm. In the case of TiO₂, the light absorptivity in a wavelength range near 250 nm is 80% or more. Thus, the light shielding member 80 containing Ti₂O₃ is formed by a reduction reaction caused by thermal energy of the laser light La. That is, in this step, excimer laser light is preferably used.

In the step illustrated in FIG. 10A and FIG. 10B, the groove 70, the light shielding member 80, and the air layer 90 may be formed by another method which is not part of the invention. For example, the groove 70 that opens at the upper surface 60a of the covering member 60 is formed by blade dicing or the like. Then, a resin containing a black filler is provided in the groove 70 and is cured. Subsequently, a portion of the resin in the groove 70 is removed by blade dicing or the like. In this manner, the resin covering the surface of the covering member 60 defining the groove 70 serves as the light shielding member 80, and a portion where the resin is removed serves as the air layer 90. Alternatively, the air layer 90 may be formed by adding a volatile solvent to a resin that contains a black filler and volatilizing the solvent.

### <Light Emitting Devices According to Modifications>

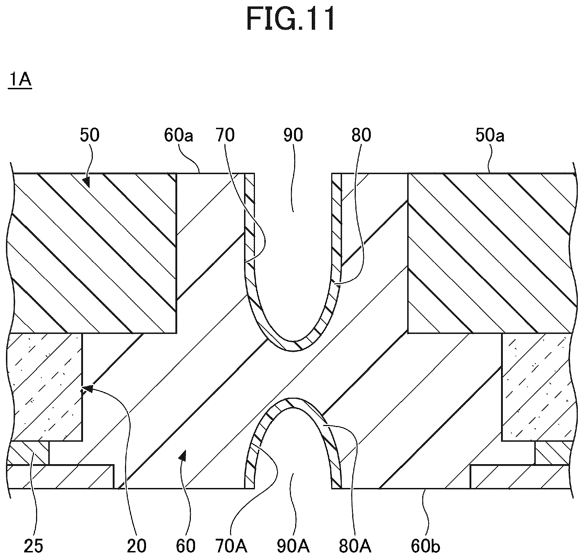

FIG. 11 is a partial cross-sectional view schematically illustrating a light emitting device according to a first modification of the embodiment and illustrates a cross section corresponding to the cross section of FIG. 5. As illustrated in FIG. 11, a light emitting device 1A differs from the light emitting device 1 in that the light emitting device 1A does not include the wiring substrate 10. In addition, the light emitting device 1A differs from the light emitting device 1 in that the light emitting device 1A further has a second groove 70A opening at a lower surface 60b of a covering member 60 and provided between adjacent light emitting elements 20; a light shielding member 80A covering the surface of the covering member 60 defining the second groove 70A; and an air layer 90A disposed on the light shielding member 80A in the second groove 70A.

The second groove 70A, the light shielding member 80A, and the air layer 90A can be provided in the same manner as a groove 70, light shielding member 80, and an air layer 90. Any relationship between the depth of the groove 70 and the depth of the second groove 70A is acceptable, and may be determined as necessary.

In the light emitting device 1A, light incident on light transmissive members 50 from light emitting elements 20 and exiting from the lateral surfaces 50c of the light transmissive members 50, and light existing directly from the lateral surfaces 20c of the light emitting elements 20 are shielded by the light shielding members 80 and 80A. Therefore, light propagating between the lateral surfaces 50c of the adjacent light transmissive members 50 can be reduced. As a result, interference of light between the adjacent light emitting elements 20 can be reduced. In particular, by providing the light shielding member 80A between the adjacent light emitting elements 20, the effect of shielding the light existing directly from the lateral surfaces 20c of the light emitting elements 20 can be improved.

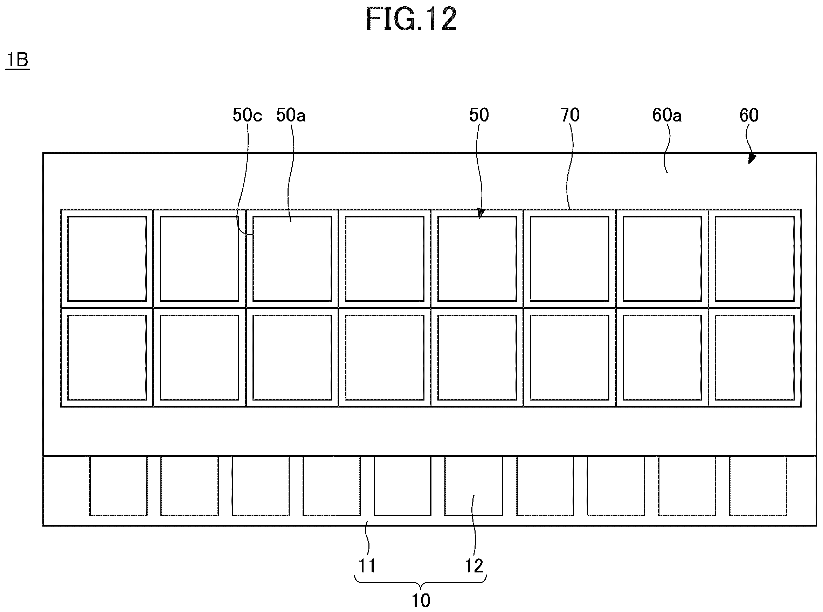

FIG. 12 is a top view schematically illustrating a light emitting device according to a second modification of the embodiment. As illustrated in FIG. 12, a light emitting device 1B differs from the light emitting device 1 in that light transmissive members 50 and light emitting elements 20 are arranged in a matrix in a top view. The light emitting elements 20 are disposed on the lower surface side of the respective light transmissive members 50.

In the example of FIG. 12, a groove 70 is provided so as to individually surround the light transmissive members 50 in a top view. As illustrated in FIG. 5, a light shielding member 80 and an air layer 90 are provided in the groove 70. That is, the light shielding member 80 and the air layer 90 are provided so as to individually surround the light transmissive member 50 in a top view. The groove 70, the light shielding member 80, and the air layer 90 may be linearly disposed between the facing sides of adjacent light transmissive members 50 in a top view.

As described, in the light emitting devices according to the present disclosure, the arrangement of light transmissive members 50 and light emitting elements 20 is not limited to one dimensional arrangement, but rather may be two dimensional arrangement. If the light transmissive members 50 and the light emitting elements 20 are arranged two dimensionally as illustrated in, for example, FIG. 12, the light transmissive members 50 and the light emitting elements 20 can be arranged in a matrix in a top view.

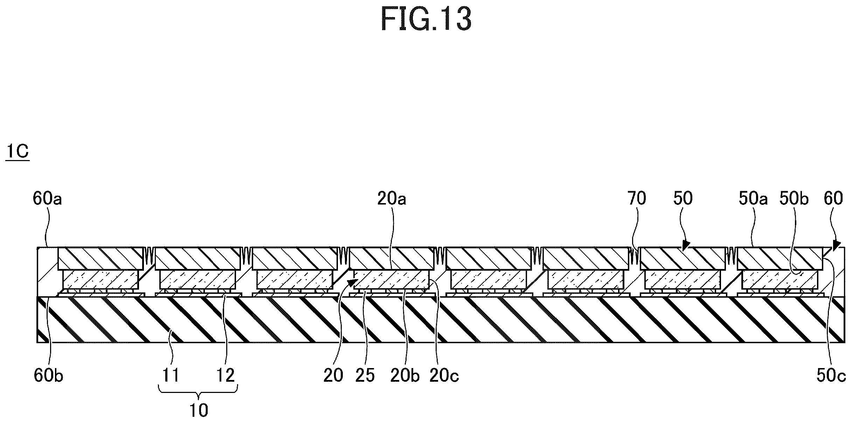

FIG. 13 is a vertical cross-sectional view schematically illustrating a light emitting device according to a third modification of the embodiment. As illustrated in FIG. 13, a light emitting device 1C differs from the light emitting device 1 in that the light emitting device 1C has two grooves 70 that open at an upper surface 60a of a covering member 60 and are provided between adjacent two light transmissive members 50. The light emitting device 1C may have three or more grooves 70 that open at the upper surface 60a of the covering member 60 and provided between the adjacent two light transmissive members 50. In the light emitting device 1C, light shielding members 80 and air layers 90 are provided in the respective grooves 70, as illustrated in FIG. 5.

In the light emitting device 1C, the grooves 70, the light shielding members 80, and the air layers 90 may be linearly disposed between the facing sides of the adjacent light transmissive members 50 in a top view, similar to FIG. 2. Alternatively, similar to FIG. 12, the grooves 70, the light shielding members 80, and the air layers 90 may be disposed to individually surround the light transmissive members 50 in a top view. Further, the widths and the depths of the plurality of grooves provided between the adjacent light transmissive members 50 may be the same or may be different.

As described, the light emitting device 1C includes the plurality of grooves 70, the light shielding members 80, and the air layers 90 between the adjacent light transmissive members 50. Accordingly, light propagating between the lateral surfaces 50c of the adjacent light transmissive members 50 can further be reduced in the light emitting device 1C, as compared to the light emitting device 1. As a result, interference of light between adjacent light emitting elements 20 can be further reduced.

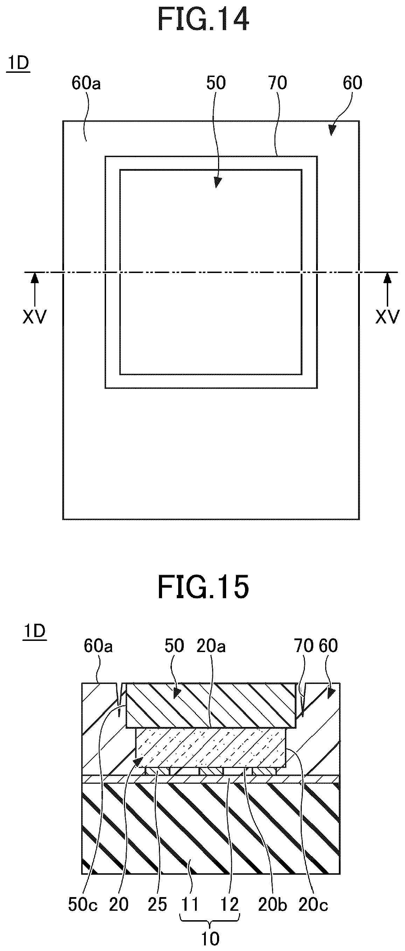

FIG. 14 is a top view schematically illustrating a light emitting device according to a fourth modification of the embodiment which is not part of the invention. . FIG. 15 is a vertical cross-sectional view of the light emitting device taken through line XV-XV of FIG. 14. As illustrated in FIG. 14 and FIG. 15, a light emitting device 1D differs from the light emitting device 1 in that the light emitting device 1D includes one light emitting element 20 and one light transmissive member 50. In the light emitting device 1D, a covering member 60 covers the entire upper surface of a base 11, for example.

A groove 70 opens at the upper surface 60a of the covering member 60 and surrounds the light transmissive member 50 in a top view. A light shielding member 80 and an air layer 90 are disposed in the groove 70 as illustrated in FIG. 5. That is, the light shielding member 80 and the air layer 90 are disposed to surround the light transmissive member 50 in a top view.

Accordingly, light incident on the light transmissive member 50 from the light emitting element 20 and exiting from the lateral surfaces 50c of the light transmissive member 50, and light existing from the lateral surfaces 20c of the light emitting element 20 are shielded by the light shielding member 80. Therefore, light propagating in a lateral direction of the light emitting device 1D can be reduced. For example, a plurality of light emitting devices 1D are arranged close to each other, interference of light between adjacent light emitting devices 1D can be reduced.

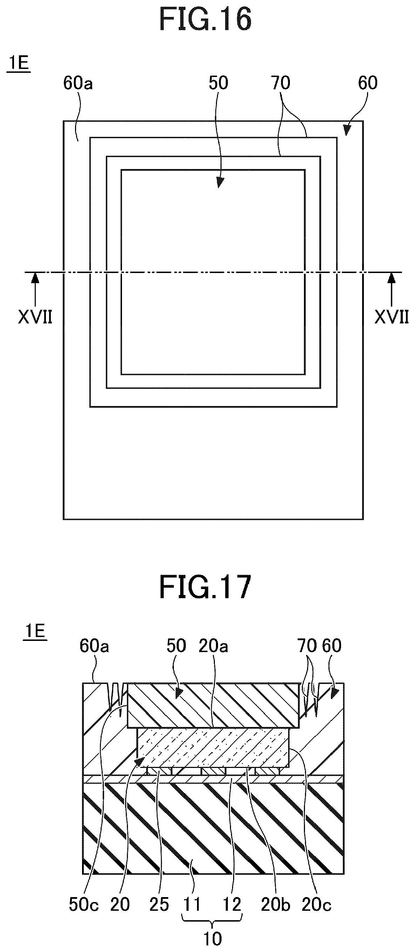

FIG. 16 is a top view schematically illustrating a light emitting device according to a fifth modification of the embodiment which is not part of the present invention . FIG. 17 is a vertical cross-sectional view of the light emitting device taken through line XVII-XVII of FIG. 16. As illustrated in FIG. 16 and FIG. 17, a light emitting device 1E differs from the light emitting device 1D in that the light emitting device 1E has two grooves 70 that open at an upper surface 60a of a covering member 60 and surround a light transmissive member 50. The light emitting device 1E may have three or more grooves 70 that open at the upper surface 60a of the covering member 60 and surround the light transmissive member 50. In the light emitting device 1E, light shielding members 80 and air layers 90 are disposed in the respective grooves 70, as illustrated in FIG. 5.

As described, the light emitting device 1E includes the plurality of grooves 70, the light shielding members 80, and the air layers 90 that surround the light transmissive member 50. Accordingly, light propagating in a lateral direction of the light emitting device 1E can be further reduced, as compared to the light emitting device 1D. As a result, for example, if a plurality of light emitting devices 1E are arranged close to each other, interference of light between adjacent light emitting devices 1E can be further reduced.

Accordingly to one embodiment of the present disclosure, in a light emitting device including a plurality of light emitting elements, a luminance difference between a turned-on light emitting element and a turned-off light emitting element can be increased.

Although embodiments and the like have been described in detail above, the present invention is not limited to the above-described embodiments, and various modifications and substitutions can be made to the above-described embodiments and the like without departing from the scope recited in the claims.

### DESCRIPTION OF THE REFERENCE NUMERALS

1, 1A, 1B, 1C, 1D, 1E light emitting device
10 wiring substrate
11 base
12 wiring
20 light emitting element
20a upper surface
20b lower surface
20c lateral surface
25 conductive member
50 light transmissive member
50a upper surface
50b lower surface
50c lateral surface
60 covering member
60a upper surface
60b lower surface
70 groove
70A second groove
80, 80A light shielding member
90, 90A air layer

## Claims

1. A light emitting device comprising:
a plurality of light emitting elements (20);
a plurality of light transmissive members (50) disposed on the respective light emitting elements (20);
a covering member (60) covering lateral surfaces (50c) of the light transmissive members (50) and lateral surfaces (20c) of the light emitting elements (20), wherein upper surfaces (50a) of the light transmissive members (50) are exposed from the covering member (60), and wherein the covering member (60) defines a first groove that opens at an upper surface (60a) of the covering member (60) and is located between adjacent ones of the light transmissive members (50);
a light shielding member (80, 80A) covering a surface of the covering member (60) that defines the first groove; and
an air layer (90, 90A) disposed on the light shielding member (80, 80A) in the first groove,
wherein the light shielding member (80, 80A) comprises a black filler, and
**characterised in that**
the covering member (60) comprises metal oxide particles, and the black filler comprises reduced oxide particles comprising a same metal as a metal constituting the metal oxide particles.

2. The light emitting device according to claim 1, wherein a distance between the adjacent ones of the light transmissive members (50) is 50 µm or less.

3. The light emitting device according to claim 1 or 2, wherein a refractive index of the light shielding member (80, 80A) is greater than a refractive index of the air layer (90, 90A).

4. The light emitting device according to any one of claims 1 to 3, wherein the covering member (60) further defines a second groove (70A) that opens at a lower surface (60b) of the covering member (60) and is located between adjacent ones of the light emitting elements (20).

5. The light emitting device according to any one of claims 1 to 4, wherein, in a top view, the light shielding member (80, 80A) is linearly disposed between facing sides of the adjacent ones of the light transmissive members (50).

6. The light emitting device according to any one of claims 1 to 5, wherein, in the top view, the light transmissive members (50) and the light emitting elements (20) are disposed in a matrix.

7. The light emitting device according to any one of claims 1 to 6, wherein, in the top view, the light shielding member (80, 80A) individually surrounds the light transmissive members (50).

8. The light emitting device according to any one of claims 1 to 7, wherein a deepest portion of the first groove is located at a position deeper than lower surfaces (50b) of the light transmissive members (50).

9. The light emitting device according to claim 8, wherein the deepest portion of the first groove is located at a position deeper than lower surfaces (20b) of the light emitting elements (20).

10. The light emitting device according to any one of claims 1 to 9, wherein a width of the first groove is 20 µm or less in a vertical cross section cut in a direction in which the light transmissive members (50) are arranged.

11. The light emitting device according to any one of claims 1 to 10, further comprising:
a substrate (10) on which the light emitting elements (20) are to be disposed.

12. A method of manufacturing a light emitting device, the method comprising:
providing an intermediate body (100) comprising:
a plurality of light emitting elements (20),
a plurality of light transmissive members (50) disposed on the respective light emitting elements (20),
a covering member (60) covering lateral surfaces (50c) of the light transmissive members (50) and lateral surfaces (20c) of the light emitting elements (20), wherein upper surfaces (50a) of the light transmissive members (50) are exposed from the covering member (60); and
forming a groove (70) by irradiating the covering member (60) with laser light such that the groove (70) opens at an upper surface (60a) of the covering member (60) and is located between adjacent ones of the light transmissive members (50),
wherein, in the forming of the groove (70), a light shielding member (80, 80A) and an air layer (90, 90A) are formed together with the groove (70), such that the light shielding member (80, 80A) covers a surface of the covering member (60) that defines the groove (70), and the air layer (90, 90A) is disposed on the light shielding member (80, 80A) in the groove (70),
wherein the light shielding member (80, 80A) comprises a black filler, and
**characterised in that**
the covering member (60) comprises metal oxide particles, and the black filler comprises reduced oxide particles obtained by a reduction reaction of the metal oxide particles.

13. The method of manufacturing the light emitting device according to claim 12, wherein the reduction reaction of the metal oxide particles is caused by thermal energy of the laser light.

14. The method of manufacturing the light emitting device according to claim 13, wherein, in the forming of the groove (70), the laser light has an emission wavelength within a wavelength range in which light absorptivity of the metal oxide particles is 80% or more.

15. The method of manufacturing the light emitting device according to claim 13 or 14, wherein the laser light is excimer laser light, and the metal oxide particles are TiO₂ particles.

## Patentansprüche

1. Lichtemittierende Vorrichtung, umfassend:
eine Mehrzahl von lichtemittierenden Elementen (20);
eine Mehrzahl von lichtdurchlässigen Bauteilen (50), die auf den jeweiligen lichtemittierenden Elementen (20) angeordnet sind;
ein Abdeckbauteil (60), das laterale Oberflächen (50c) der lichtdurchlässigen Bauteile (50) und laterale Oberflächen (20c) der lichtemittierenden Elemente (20) bedeckt, wobei obere Oberflächen (50a) der lichtdurchlässigen Bauteile (50) von dem Abdeckbauteil (60) freiliegen, und wobei das Abdeckbauteil (60) eine erste Rille definiert, die sich an einer oberen Oberfläche (60a) des Abdeckbauteils (60) öffnet und die zwischen benachbarten lichtdurchlässigen Bauteilen (50) lokalisiert ist;
ein Lichtabschirmungsbauteil (80, 80A), das eine Oberfläche des Abdeckbauteils (60) bedeckt, das die erste Rille definiert; und
eine Luftschicht (90, 90A), die auf dem Lichtabschirmungsbauteil (80, 80A) in der ersten Rille angeordnet ist,
wobei das Lichtabschirmungsbauteil (80, 80A) einen schwarzen Füllstoff umfasst, und
**dadurch gekennzeichnet, dass**
das Abdeckbauteil (60) Metalloxidpartikel umfasst, und der schwarze Füllstoff reduzierte Oxidpartikel umfasst, die das gleiche Metall umfassen, wie ein Metall, aus dem die Metalloxidpartikel gebildet sind.

2. Lichtemittierende Vorrichtung nach Anspruch 1, wobei ein Abstand zwischen den benachbarten lichtdurchlässigen Bauteilen (50) 50 µm oder weniger ist.

3. Lichtemittierende Vorrichtung nach Anspruch 1 oder 2, wobei ein Brechungsindex des Lichtabschirmungsbauteils (80, 80A) größer ist als ein Brechungsindex der Luftschicht (90, 90A).

4. Lichtemittierende Vorrichtung nach einem der Ansprüche 1 bis 3, wobei das Abdeckbauteil (60) ferner eine zweite Rille (70A) definiert, die sich an einer unteren Oberfläche (60b) des Abdeckbauteils (60) öffnet und die zwischen benachbarten lichtemittierenden Elementen (20) lokalisiert ist.

5. Lichtemittierende Vorrichtung nach einem der Ansprüche 1 bis 4, wobei in einer Draufsicht das Lichtabschirmungsbauteil (80, 80A) linear zwischen einander zugewandten Seiten der benachbarten lichtdurchlässigen Bauteile (50) angeordnet ist.

6. Lichtemittierende Vorrichtung nach einem der Ansprüche 1 bis 5, wobei in der Draufsicht die lichtdurchlässigen Bauteile (50) und die lichtemittierenden Elemente (20) in einer Matrix angeordnet sind.

7. Lichtemittierende Vorrichtung nach einem der Ansprüche 1 bis 6, wobei in der Draufsicht das Lichtabschirmungsbauteil (80, 80A) die lichtdurchlässigen Bauteile (50) individuell umgibt.

8. Lichtemittierende Vorrichtung nach einem der Ansprüche 1 bis 7, wobei ein tiefster Bereich der ersten Rille an einer Position lokalisiert ist, die tiefer als untere Oberflächen (50b) der lichtdurchlässigen Bauteile (50) ist.

9. Lichtemittierende Vorrichtung nach Anspruch 8, wobei der tiefste Bereich der ersten Rille an einer Position lokalisiert ist, die tiefer als untere Oberflächen (20b) der lichtemittierenden Elemente (20) ist.

10. Lichtemittierende Vorrichtung nach einem der Ansprüche 1 bis 9, wobei eine Breite der ersten Rille 20 µm oder weniger in einem vertikalen Querschnitt beträgt, der in einer Richtung geschnitten ist, in der die lichtdurchlässigen Bauteile (50) angeordnet sind.

11. Lichtemittierende Vorrichtung nach einem der Ansprüche 1 bis 10, ferner umfassend:
ein Substrat (10), auf dem die lichtemittierenden Elemente (20) anzuordnen sind.

12. Verfahren zur Herstellung einer lichtemittierenden Vorrichtung, wobei das Verfahren umfasst:
Bereitstellen eines Zwischenkörpers (100), umfassend:
eine Mehrzahl von lichtemittierenden Elementen (20),
eine Mehrzahl von lichtdurchlässigen Bauteilen (50), die auf den jeweiligen lichtemittierenden Elementen (20) angeordnet sind,
ein Abdeckbauteil (60), das laterale Oberflächen (50c) der lichtdurchlässigen Bauteile (50) und laterale Oberflächen (20c) der lichtemittierenden Elemente (20) bedeckt, wobei obere Oberflächen (50a) der lichtdurchlässigen Bauteile (50) von dem Abdeckbauteil (60) freiliegen; und
Bilden einer Rille (70) durch Bestrahlen des Abdeckbauteils (60) mit Laserlicht derart, dass sich die Rille (70) an einer oberen Oberfläche (60a) des Abdeckbauteils (60) öffnet und zwischen benachbarten lichtdurchlässigen Bauteilen (50) lokalisiert ist,
wobei beim Bilden der Rille (70) ein Lichtabschirmungsbauteil (80, 80A) und eine Luftschicht (90, 90A) zusammen mit der Rille (70) derart gebildet werden, dass das Lichtabschirmungsbauteil (80, 80A) eine Oberfläche des Abdeckbauteils (60) bedeckt, das die Rille (70) definiert, und die Luftschicht (90, 90A) auf dem Lichtabschirmungsbauteil (80, 80A) in der Rille (70) angeordnet ist,
wobei das Lichtabschirmungsbauteil (80, 80A) einen schwarzen Füllstoff umfasst, und
**dadurch gekennzeichnet, dass**
das Abdeckbauteil (60) Metalloxidpartikel umfasst, und der schwarze Füllstoff reduzierte Oxidpartikel umfasst, die durch eine Reduktionsreaktion der Metalloxidpartikel erhalten werden.

13. Verfahren zur Herstellung der lichtemittierenden Vorrichtung nach Anspruch 12, wobei die Reduktionsreaktion der Metalloxidpartikel durch thermische Energie des Laserlichts verursacht wird.

14. Verfahren zur Herstellung der lichtemittierenden Vorrichtung nach Anspruch 13, wobei beim Bilden der Rille (70) das Laserlicht eine Emissionswellenlänge innerhalb eines Wellenlängenbereichs hat, in dem das Lichtabsorptionsvermögen der Metalloxidpartikel 80% oder mehr ist.

15. Verfahren zur Herstellung der lichtemittierenden Vorrichtung nach Anspruch 13 oder 14, wobei das Laserlicht Excimerlaserlicht ist, und die Metalloxidpartikel TiO₂-Partikel sind.

## Revendications

1. Dispositif électroluminescent comprenant :
une pluralité d'éléments électroluminescents (20) ;
une pluralité d'éléments de transmission de lumière (50) disposés sur les éléments électroluminescents (20) respectifs ;
un élément de recouvrement (60) recouvrant des surfaces latérales (50c) des éléments de transmission de lumière (50) et des surfaces latérales (20c) des éléments électroluminescents (20), dans lequel des surfaces supérieures (50a) des éléments de transmission de lumière (50) sont exposées depuis l'élément de recouvrement (60), et dans lequel l'élément de recouvrement (60) définit une première rainure qui s'ouvre au niveau d'une surface supérieure (60a) de l'élément de recouvrement (60) et est située entre des éléments adjacents parmi les éléments de transmission de lumière (50) ;
un élément de protection contre la lumière (80, 80A) recouvrant une surface de l'élément de recouvrement (60) qui définit la première rainure ; et
une couche d'air (90, 90A) disposée sur l'élément de protection contre la lumière (80, 80A) dans la première rainure,
dans lequel l'élément de protection contre la lumière (80, 80A) comprend une charge noire, et
**caractérisé en ce que** l'élément de recouvrement (60) comprend des particules d'oxyde métallique, et la charge noire comprend des particules d'oxyde réduites comprenant un même métal qu'un métal constituant les particules d'oxyde métallique.

2. Dispositif électroluminescent selon la revendication 1, dans lequel une distance entre les éléments adjacents parmi les éléments de transmission de lumière (50) est de 50 µm ou moins.

3. Dispositif électroluminescent selon la revendication 1 ou 2, dans lequel un indice de réfraction de l'élément de protection contre la lumière (80, 80A) est supérieur à un indice de réfraction de la couche d'air (90, 90A).

4. Dispositif électroluminescent selon l'une quelconque des revendications 1 à 3, dans lequel l'élément de recouvrement (60) définit en outre une deuxième rainure (70A) qui s'ouvre au niveau d'une surface inférieure (60b) de l'élément de recouvrement (60) et est située entre des éléments adjacents parmi les éléments électroluminescents (20).

5. Dispositif électroluminescent selon l'une quelconque des revendications 1 à 4, dans lequel, dans une vue de dessus, l'élément de protection contre la lumière (80, 80A) est disposé linéairement entre des côtés opposés des éléments adjacents parmi les éléments de transmission de lumière (50).

6. Dispositif électroluminescent selon l'une quelconque des revendications 1 à 5, dans lequel, dans la vue de dessus, les éléments de transmission de lumière (50) et les éléments électroluminescents (20) sont disposés selon une matrice.

7. Dispositif électroluminescent selon l'une quelconque des revendications 1 à 6, dans lequel, dans la vue de dessus, l'élément de protection contre la lumière (80, 80A) entoure individuellement les éléments de transmission de lumière (50).

8. Dispositif électroluminescent selon l'une quelconque des revendications 1 à 7, dans lequel une partie la plus profonde de la première rainure est située au niveau d'une position plus profonde que les surfaces inférieures (50b) des éléments de transmission de lumière (50).

9. Dispositif électroluminescent selon la revendication 8, dans lequel la partie la plus profonde de la première rainure est située au niveau d'une position plus profonde que les surfaces inférieures (20b) des éléments électroluminescents (20).

10. Dispositif électroluminescent selon l'une quelconque des revendications 1 à 9, dans lequel une largeur de la première rainure est de 20 µm ou moins dans une section transversale verticale coupée dans une direction dans laquelle les éléments de transmission de lumière (50) sont disposés.

11. Dispositif électroluminescent selon l'une quelconque des revendications 1 à 10, comprenant en outre :
un substrat (10) sur lequel les éléments électroluminescents (20) sont destinés à être disposés.

12. Procédé de fabrication d'un dispositif électroluminescent, le procédé comprenant :
la fourniture d'un corps intermédiaire (100) comprenant :
une pluralité d'éléments électroluminescents (20),
une pluralité d'éléments de transmission de lumière (50) disposés sur les éléments électroluminescents (20) respectifs,
un élément de recouvrement (60) recouvrant des surfaces latérales (50c) des éléments de transmission de lumière (50) et des surfaces latérales (20c) des éléments électroluminescents (20), dans lequel des surfaces supérieures (50a) des éléments de transmission de lumière (50) sont exposées depuis l'élément de recouvrement (60) ; et
la formation d'une rainure (70) en irradiant l'élément de recouvrement (60) avec une lumière laser de telle sorte que la rainure (70) s'ouvre au niveau d'une surface supérieure (60a) de l'élément de recouvrement (60) et est située entre des éléments adjacents parmi les éléments de transmission de lumière (50),
dans lequel, lors de la formation de la rainure (70), un élément de protection contre la lumière (80, 80A) et une couche d'air (90, 90A) sont formés ensemble avec la rainure (70), de telle sorte que l'élément de protection contre la lumière (80, 80A) recouvre une surface de l'élément de recouvrement (60) qui définit la rainure (70), et la couche d'air (90, 90A) est disposée sur l'élément de protection contre la lumière (80, 80A) dans la rainure (70),
dans lequel l'élément de protection contre la lumière (80, 80A) comprend une charge noire, et
**caractérisé en ce que** l'élément de recouvrement (60) comprend des particules d'oxyde métallique, et la charge noire comprend des particules d'oxyde réduites obtenues par une réaction de réduction des particules d'oxyde métallique.

13. Procédé de fabrication du dispositif électroluminescent selon la revendication 12, dans lequel la réaction de réduction des particules d'oxyde métallique est provoquée par l'énergie thermique de la lumière laser.

14. Procédé de fabrication du dispositif électroluminescent selon la revendication 13, dans lequel, lors de la formation de la rainure (70), la lumière laser présente une longueur d'onde d'émission dans une plage de longueurs d'onde dans laquelle l'absorptivité de lumière des particules d'oxyde métallique est de 80 % ou plus.

15. Procédé de fabrication du dispositif électroluminescent selon la revendication 13 ou 14, dans lequel la lumière laser est une lumière laser à excimère, et les particules d'oxyde métallique sont des particules de TiO₂.
